# EUROPEAN PATENT APPLICATION

(11) **EP 4 753 075 A1**
(43) Date of publication of application: **03.06.2026**
(21) Application number: 24860525.5
(22) Date of filing: 20.08.2024
(51) Int. Cl.: H01R 12/51, H01R 13/6466, H01R 24/00

(54) **ELECTRONIC DEVICE COMPRISING CONNECTOR**

(30) Priority: 28.08.2023 KR 20230112902; 22.09.2023 KR 20230127045
(71) Applicant: Samsung Electronics Co., Ltd., Suwon-si, Gyeonggi-do 16677 (KR)
(72) Inventor: CHOI, Seokho, Suwon-si, Gyeonggi-do 16677 (KR); KIM, Hyoungkwon, Suwon-si, Gyeonggi-do 16677 (KR); PARK, Wonbin, Suwon-si, Gyeonggi-do 16677 (KR); SHIN, Jongwoo, Suwon-si, Gyeonggi-do 16677 (KR); LEE, Seunghwan, Suwon-si, Gyeonggi-do 16677 (KR); LEE, Hanyeop, Suwon-si, Gyeonggi-do 16677 (KR); LIM, Gun, Suwon-si, Gyeonggi-do 16677 (KR); CHOI, Taihwan, Suwon-si, Gyeonggi-do 16677 (KR)
(74) Representative: Gulde & Partner
(86) International application number: PCT/KR2024/096051
(87) International publication number: WO 2025/048609

(57) **Abstract**

An electronic device according to one embodiment of the present disclosure comprises: a housing; a support member arranged in the housing; a first printed circuit board arranged on the support member; a second printed circuit board arranged on the support member and positioned at a distance from the first printed circuit board; a cable for electrically connecting the first printed circuit board and the second printed circuit board; and a connector arranged on the first printed circuit board and/or the second printed circuit board, wherein the connector can include: a first connection part for RF calibration, which protrudes in a first direction of the first printed circuit board and the second printed circuit board; and a second connection part which protrudes in a second direction opposite to the first direction of the first printed circuit board and the second printed circuit board, and which is connected to the cable.

## Description

### [Technical Field]

The disclosure relates to an electronic device including a connector.

### [Background Art]

An electronic device may include a battery having a high capacity, which may increase the area occupied by the battery inside the electronic device. An electronic device may include one or more printed circuit boards. The printed circuit boards may be respectively disposed in one direction and the other direction of the battery. A printed circuit board may include an antenna structure for wireless communication.

Respective printed circuit boards (e.g., the first printed circuit board and the second printed circuit board) positioned with a battery interposed therebetween may be electrically connected to each other through a cable (e.g., a coaxial cable). For example, an RF signal may be transmitted between two printed circuit boards through the cable.

### [Disclosure of Invention]

### [Solution to Problem]

An electronic device may include a fixing structure (e.g., a fixing protrusion) configured to fix a cable inside the electronic device. However, parasitic resonance may occur due to the fixing structure for fixing the cable, and an RF signal may be attenuated.

When a clamp is applied to the cable, a grounding structure formed by the clamp may remove or reduce a parasitic resonance phenomenon. However, when the electronic device includes a plurality of cables, a grounding failure may occur in some cables, making it difficult to remove or reduce the parasitic resonance phenomenon.

According to an embodiment of the disclosure, an electronic device may include a housing, a support member disposed in the housing, a first printed circuit board disposed on the support member, a second printed circuit board disposed on the support member and positioned at a distance from the first printed circuit board, a cable configured to electrically connect the first printed circuit board and the second printed circuit board, and a connector disposed on at least one of the first printed circuit board and the second printed circuit board. The connector may include a first connection portion protruding in a first direction of the first printed circuit board and the second printed circuit board and configured for RF calibration, and a second connection portion protruding in a second direction opposite to the first direction of the first printed circuit board and the second printed circuit board and connected to the cable.

According to an embodiment of the disclosure, a connector may include a first connection portion protruding in a first direction and configured for RF calibration, a second connection portion protruding in a second direction opposite to the first direction and connected to a cable for RF signal transmission, a base plate including an opening through which at least a portion of the first connection portion extends, a first contact member configured to contact a printed circuit board on which at least a portion of the connector is disposed, and a second contact member configured to contact the cable and be electrically connected thereto.

An electronic device according to an embodiment of the disclosure may include a connector structure that enables grounding between a cable and a support member (e.g., a bracket), thereby removing or reducing a parasitic resonance phenomenon even without applying a separate clamp structure.

A connector according to an embodiment of the disclosure may include a structure that enables cable coupling in both directions, thereby reducing time required for an RF calibration process.

### [Brief Description of Drawings]

FIG. 1 is a block diagram of an electronic device according to an embodiment in a network environment.
FIG. 2 is a view illustrating an electronic device according to an embodiment of the disclosure.
FIG. 3 is a view illustrating a connector according to an embodiment of the disclosure.
FIG. 4 is an exploded perspective view illustrating the connector according to an embodiment of the disclosure.
FIG. 5 is a view illustrating a connector and a printed circuit board according to an embodiment of the disclosure.
FIGS. 6A, 6B, and 6C are views illustrating a connector disposed on a printed circuit board according to an embodiment of the disclosure.
FIGS. 7A and 7B are views illustrating a state in which a first cable is connected to a connector according to an embodiment of the disclosure.
FIGS. 8A and 8B are views illustrating a state in which a second cable is connected to a connector according to an embodiment of the disclosure.
FIGS. 9A and 9B illustrate states in which a first cable and a second cable are connected to a connector the according to an embodiment disclosed herein.
FIGS. 10A and 10B are views illustrating electronic devices according to an embodiment.
FIGS. 11 and 12 are graphs illustrating noise simulation results of the electronic devices.

### [Mode for the Invention]

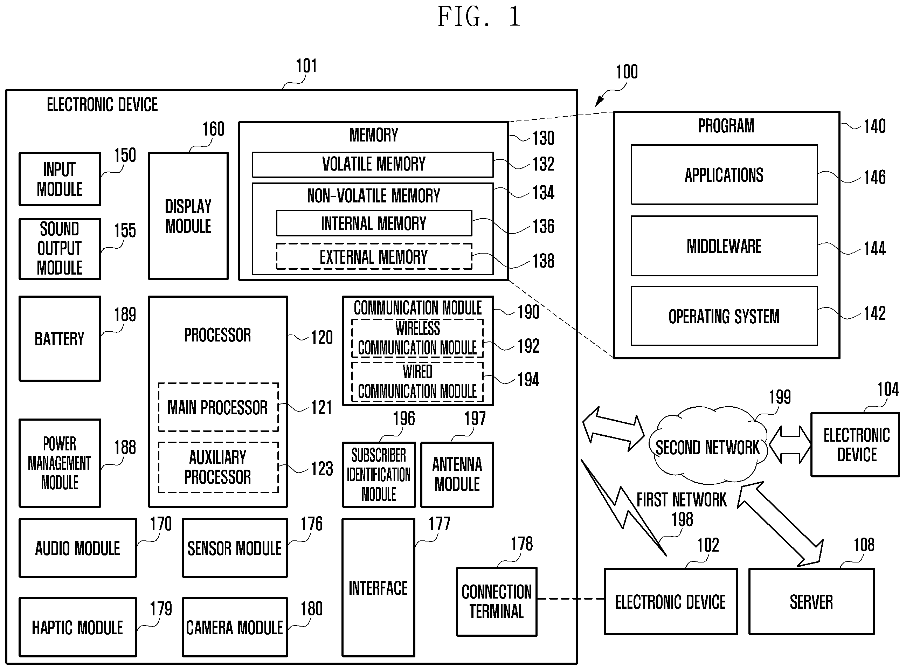

Fig. 1 is a block diagram illustrating an electronic device 101 in a network environment 100 according to an embodiment. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

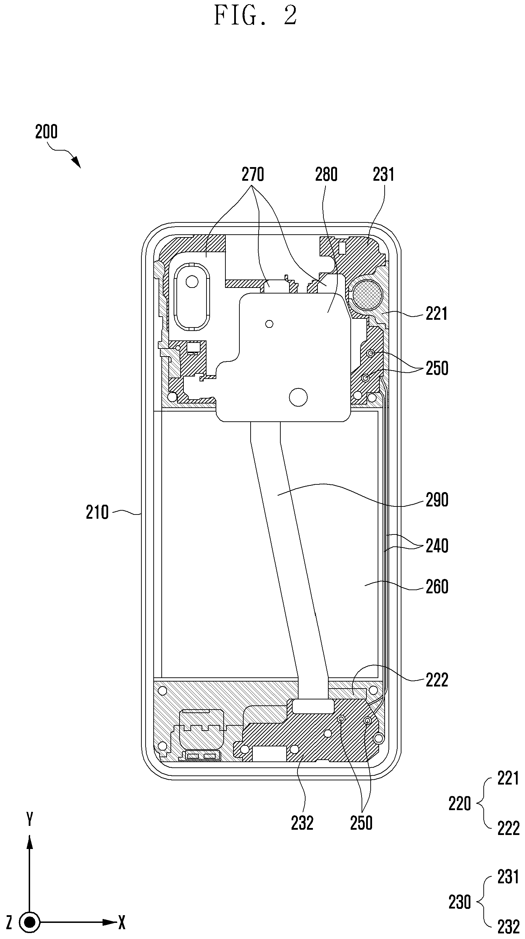

FIG. 2 is a view illustrating an electronic device 200 according to an embodiment of the disclosure.

The electronic device 200 illustrated in FIG. 2 may refer to the electronic device 101 of FIG. 1, or may include at least a portion of the electronic device 101.

In describing the electronic device 200 according to an embodiment of the disclosure, a width direction of the electronic device 200 may refer to an X-axis direction illustrated in FIG. 2, and a length direction may refer to a Y-axis direction illustrated in FIG. 2. A height direction of the electronic device 200 may refer to a Z-axis direction illustrated in FIG. 2.

The electronic device 200 according to an embodiment of the disclosure may include a housing 210, a support member 220, a printed circuit board 230, a cable 240, a connector 250, a battery 260, a shield can 270, a heat transfer member 280, and/or a flexible printed circuit board 290.

In an embodiment, the housing 210 may be a component forming an exterior of the electronic device 200. The housing 210 may extend in the width direction (e.g., the X-axis direction) and the length direction (e.g., the Y-axis direction) of the electronic device 200.

In an embodiment, other components of the electronic device 200 (e.g., the printed circuit board 230 and the battery 260) may be disposed inside the housing 210.

In an embodiment, the support member 220 may be disposed in the housing 210. In an embodiment, the support member 220 may serve to support the printed circuit board 230. In an embodiment, the support member 220 may serve to fix the printed circuit board 230 so that the printed circuit board 230 maintains a predetermined position.

In an embodiment, the printed circuit board 230 may be disposed inside the housing 210. The printed circuit board 230 may be supported by the support member 220 inside the housing 210.

In an embodiment, the printed circuit board 230 may have a processor (e.g., the processor 120 of FIG. 1), memory (e.g., the memory 130 of FIG. 1), and/or an interface (e.g., the interface 177 of FIG. 1) mounted thereon. The processor may include, for example, one or more of a central processing unit, an application processor, a graphics processing unit, an image signal processor, a sensor hub processor, or a communication processor. According to an embodiment, the memory may include, for example, volatile memory or nonvolatile memory. According to an embodiment, the interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector.

In an embodiment, the battery 260 may serve as a device that supplies power to at least one component of the electronic device 200, and may include, for example, a non-rechargeable primary cell, a rechargeable secondary cell, or a fuel cell. In an embodiment, the battery 260 may be disposed in the housing 210.

In an embodiment, the shield can 270 may be disposed on one surface of the printed circuit board 230. For example, the shield can 270 may be disposed on one surface of the printed circuit board 230 so as to surround at least a portion of an electronic component (e.g., the processor 120 of FIG. 1). In an embodiment, the shield can 270 may serve to shield noise generated from the electronic component (e.g., the processor 120 of FIG. 1).

In an embodiment, the heat transfer member 280 may be disposed so as to cover at least a portion of the shield can 270. The heat transfer member 280 may serve to diffuse heat generated from the electronic component (e.g., the processor 120 of FIG. 1) to other regions of the electronic device 200.

In an embodiment, the support member 220 may include a first support member 221 and/or a second support member 222.

In an embodiment, the printed circuit board 230 may include a first printed circuit board 231 and/or a second printed circuit board 232.

In an embodiment, the first printed circuit board 231 may be supported by the first support member 221. The second printed circuit board 232 may be supported by the second support member 222.

In an embodiment, the first printed circuit board 231 and the second printed circuit board 232 may be disposed to be spaced apart from each other. For example, the first printed circuit board 231 and the second printed circuit board 232 may be disposed with the battery 260 interposed therebetween. Referring to FIG. 2, the first printed circuit board 231 may be disposed in the positive Y-axis direction with respect to the battery 260, and the second printed circuit board 232 may be disposed in the negative Y-axis direction with respect to the battery 260.

In an embodiment, the flexible printed circuit board 290 may extend between the first printed circuit board 231 and the second printed circuit board 232. The flexible printed circuit board 290 according to an embodiment may electrically connect the first printed circuit board 231 and the second printed circuit board 232. In an embodiment, at least a portion of the flexible printed circuit board 290 may be disposed to overlap the battery 260.

In an embodiment, the cable 240 may electrically connect the first printed circuit board 231 and the second printed circuit board 232. In an embodiment, the cable 240 may be a coaxial cable for radio frequency (RF) signal transmission.

In an embodiment, at least a portion of the cable 240 may extend along the length direction of the electronic device 200 (e.g., the Y-axis direction). For example, referring to FIG. 2, at least a portion of the cable 240 may be disposed on one side of the battery 260 (e.g., a side in the positive X-axis direction with respect to the battery 260) and may extend along the length direction of the electronic device 200 (e.g., the Y-axis direction).

In an embodiment, the connector 250 may be disposed on the printed circuit board 230. For example, the connector 250 may be disposed on the first printed circuit board 231 and/or the second printed circuit board 232.

Although FIG. 2 illustrates that the connector 250 is disposed on each of the first printed circuit board 231 and the second printed circuit board 232, this is merely exemplary, and the connector 250 may be disposed only on one of the first printed circuit board 231 and the second printed circuit board 232.

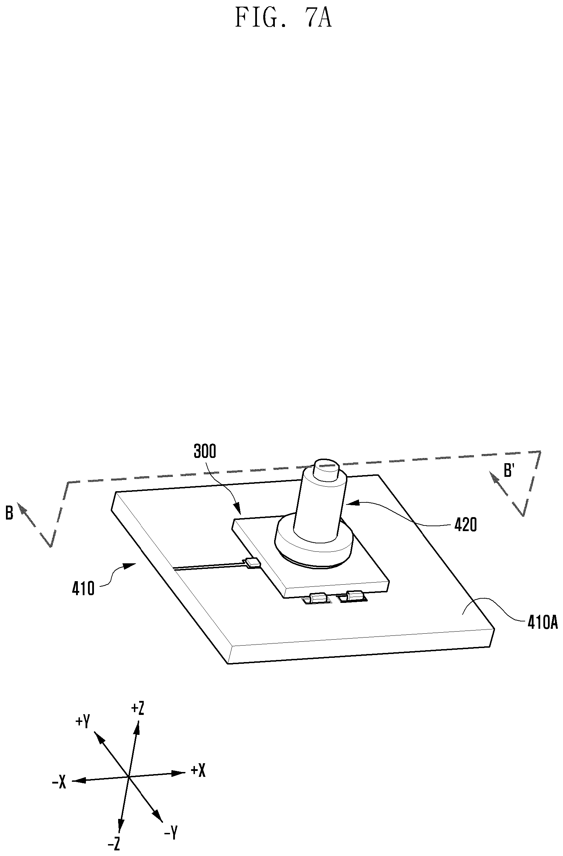

In an embodiment, a cable 240 for RF signal transmission and a cable for RF calibration (e.g., the first cable 420 of FIG. 7A) may each be connected to the connector 250 according to an embodiment. For example, the connector 250 may be connected to the cable 240 for RF signal transmission in one direction (e.g., the negative Z-axis direction), and may be connected to the cable (e.g., the first cable 420 of FIG. 7A) for RF calibration in the other direction (e.g., the positive Z-axis direction), which is opposite to the one direction.

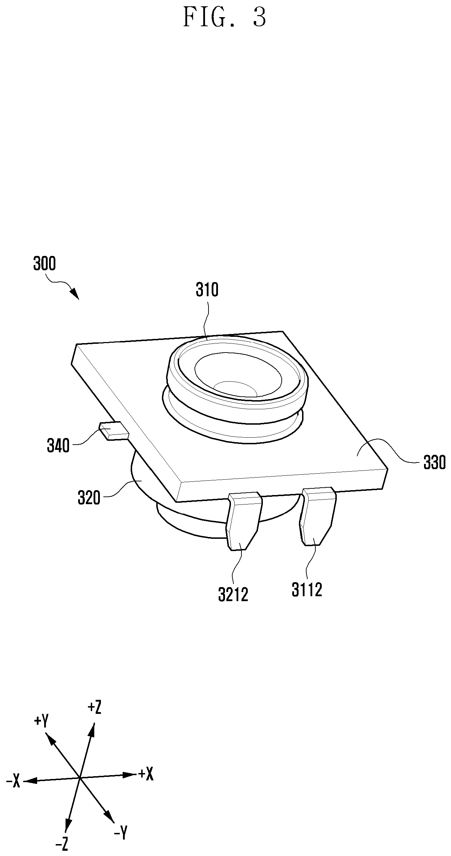

FIG. 3 is a view illustrating a connector 300 according to an embodiment of the disclosure.

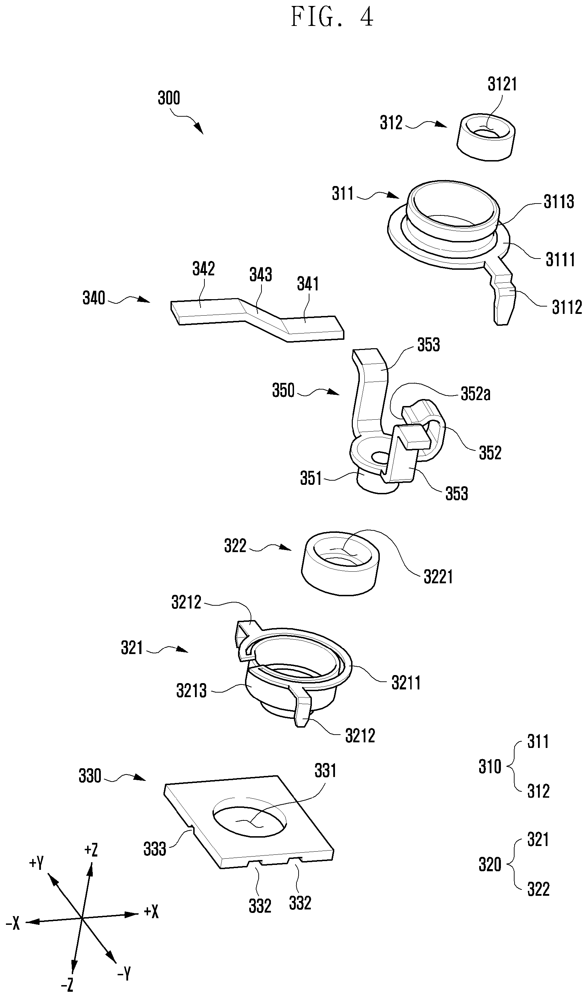

FIG. 4 is an exploded perspective view illustrating the connector 300 according to an embodiment of the disclosure.

The connector 300 illustrated in FIGS. 3 and 4 may refer to the connector 250 of FIG. 2, or may include at least a portion of the connector 250.

In describing the connector 300 according to an embodiment of the disclosure, the width direction of the connector 300 may refer to the X-axis direction, and the length direction may refer to the Y-axis direction. The height direction of the connector 300 may refer to the Z-axis direction.

The connector 300 according to an embodiment of the disclosure may include a first connection portion 310, a second connection portion 320, a base plate 330, a first contact member 340, and/or a second contact member 350.

In an embodiment, a first direction of the connector 300 may refer to the positive Z-axis direction with respect to the connector 300. A second direction of the connector 300 may refer to the negative Z-axis direction with respect to the connector 300.

In an embodiment, at least a portion of the first connection portion 310 may protrude in the first direction of the connector 300. At least a portion of the second connection portion 320 may protrude in the second direction of the connector 300.

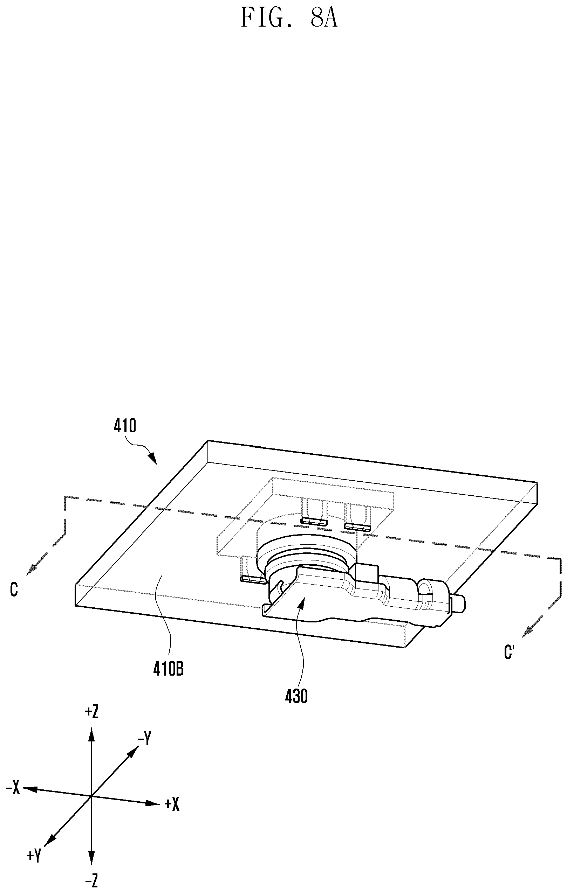

In an embodiment, the connector 300 may be connected to a first cable 420 (see FIG. 7A) and a second cable 430 (see FIG. 8A). The first cable 420 (see FIG. 7A) may be a cable for RF calibration. The second cable 430 (see FIG. 8A) may be a coaxial cable for RF signal transmission.

In an embodiment, the first cable 420 (see FIG. 7A) may be coupled to the first connection portion 310. In an embodiment, the second cable 430 (see FIG. 8A) may be coupled to the second connection portion 320.

In an embodiment, the base plate 330 may include a plate shape. For example, the base plate 330 may have a plate shape formed substantially perpendicular to the height direction of the connector 300 (e.g., the Z-axis direction).

In an embodiment, the base plate 330 may include an opening 331, first guide grooves 332, and/or a second guide groove 333.

In an embodiment, at least a portion of the connection portions 310 and 320 may be disposed to pass through the opening 331 of the base plate 330. For example, referring to FIG. 3, at least a portion of the first connection portion 310 may be disposed to pass through the opening 331 of the base plate 330.

In an embodiment, the first connection portion 310 may include a first conductive member 311 and/or a first filling member 312.

In an embodiment, the first conductive member 311 may include a conductive material. In an embodiment, the first filling member 312 may include a non-conductive material.

In an embodiment, the first conductive member 311 may include a first base region 3111, first fixing regions 3112, and/or a first coupling region 3113.

In an embodiment, the first base region 3111 may be a region that contacts the second connection portion 320. The first base region 3111 may be formed substantially perpendicular to the height direction of the connector 300 (e.g., the Z-axis direction).

In an embodiment, the first fixing regions 3112 may be formed on at least a portion of the first base region 3111. For example, referring to FIG. 4, the first fixing regions 3112 may be formed to extend from one side of the first base region 3111 (e.g., a negative Y-axis direction side surface).

In an embodiment, at least a portion of the first fixing regions 3112 may be curved and extend. For example, the first fixing regions 3112 may extend in the length direction of the connector 300 (e.g., the Y-axis direction), be curved, and then extend in the height direction of the connector 300 (e.g., the Z-axis direction).

In an embodiment, the first coupling region 3113 may extend from the first base region 3111 in the height direction of the connector 300 (e.g., the Z-axis direction). In an embodiment, the first coupling region 3113 may include a cylindrical shape. The first connection portion 310 according to an embodiment may be coupled to the first cable 420 (see FIG. 7A) at the first coupling region 3113.

In an embodiment, the first filling member 312 may be disposed inside the first conductive member 311. The first filling member 312 may fill at least a portion of a space formed inside the first conductive member 311.

In an embodiment, the first filling member 312 may include a first insertion space 3121. At least a portion of the first cable 420 (see FIG. 7A) may be inserted into the first insertion space 3121.

In an embodiment, the second connection portion 320 may include a second conductive member 321 and/or a second filling member 322.

In an embodiment, the second conductive member 321 may include a conductive material. In an embodiment, the second filling member 322 may include a non-conductive material.

In an embodiment, the second conductive member 321 may include a second base region 3211, second fixing regions 3212, and/or a second coupling region 3213.

In an embodiment, the second base region 3211 may be a region that contacts the first connection portion 310. The second base region 3211 may be formed substantially perpendicular to the height direction of the connector 300 (e.g., the Z-axis direction).

In an embodiment, the second fixing regions 3212 may be formed on at least a portion of the second base region 3211. For example, referring to FIG. 4, the second fixing regions 3212 may be formed on one side of the second base region 3211 (e.g., the negative Y-axis direction side) and on the other side thereof (e.g., the positive Y-axis direction side).

In an embodiment, the second fixing regions 3212 may extend while being bent at least in part. For example, the second fixing regions 3212 may extend in the length direction of the connector 300 (e.g., the Y-axis direction), be curved, and then extend in the height direction of the connector 300 (e.g., the Z-axis direction).

In an embodiment, the second coupling region 3213 may extend from the second base region 3211 in the height direction of the connector 300 (e.g., the Z-axis direction). In an embodiment, the second coupling region 3213 may include a cylindrical shape. The second connection portion 320 according to an embodiment may be coupled to the second cable 430 (see FIG. 8A) at the second coupling region 3213.

In an embodiment, the second filling member 322 may be disposed inside the second conductive member 321. The second filling member 322 may fill at least a portion of a space formed inside the second conductive member 321.

In an embodiment, the second filling member 322 may include a second insertion space 3221. At least a portion of the second contact member 350 may be disposed in the second insertion space 3221.

In an embodiment, the first guide grooves 332 of the base plate 330 may be grooves formed to allow the first fixing regions 3112 and the second fixing regions 3212 to be at least partially disposed on the base plate 330. For example, the first fixing regions 3112 and the second fixing regions 3212 may be respectively disposed at least partially in the first guide grooves 332 of the base plate 330. The first fixing regions 3112 and the second fixing regions 3212 may be respectively disposed at least partially in the first guide grooves 332, and the first fixing regions 3112 and the second fixing regions 3212 may thereby maintain predetermined positions in the connector 300.

In an embodiment, the first contact member 340 may include a contact region 341, a placement region 342, and/or an inclined region 343.

In an embodiment, the contact region 341 of the first contact member 340 may be in contact with or spaced apart from the terminal end 352a of the second contact member 350. For example, the contact region 341 of the first contact member 340 may be in contact with or spaced apart from the terminal end 352a of the second contact member 350 based on a coupling state between the first connection portion 310 and the first cable 420 (see FIG. 7A).

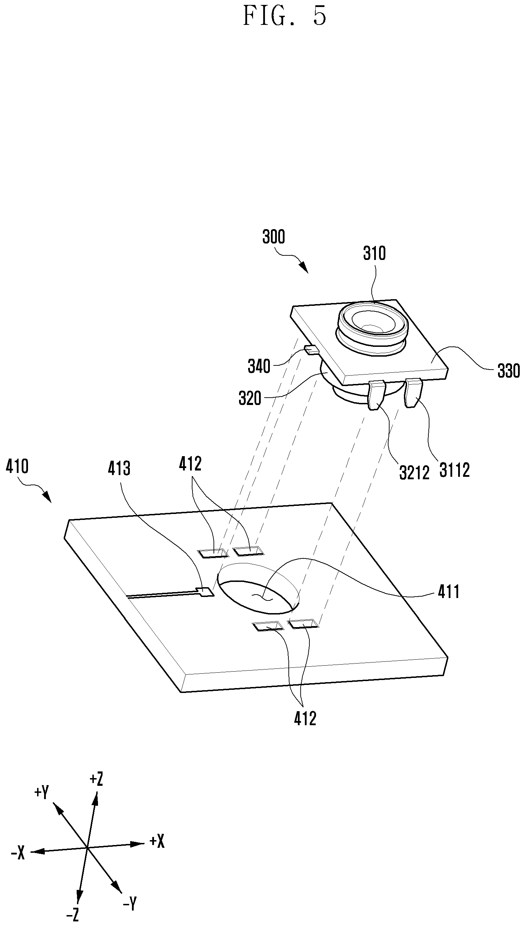

In an embodiment, the placement region 342 of the first contact member 340 may be a region to be disposed on the printed circuit board 410 (see FIG. 5). For example, the placement region 342 of the first contact member 340 may be disposed on one surface of the printed circuit board 410 (see FIG. 5) and may be electrically connected to the printed circuit board 410 (see FIG. 5).

In an embodiment, the inclined region 343 of the first contact member 340 may be a region extending between the contact region 341 and the placement region 342. For example, the inclined region 343 may extend in an inclined direction with respect to a direction in which the contact region 341 and the placement region 342 extend, between the contact region 341 and the placement region 342.

In an embodiment, the first contact member 340 may include an elastic material. The first contact member 340 may include an elastic material and may be elastically deformed in shape by an external force applied to the first contact member 340.

In an embodiment, the second contact member 350 may include a first region 351, a second region 352, and/or a third region 353.

In an embodiment, the first region 351 may be a region extending in the second direction of the connector 300 (e.g., the negative Z-axis direction). The first region 351 may be configured to contact a terminal end of the second cable 430 (see FIG. 8A).

In an embodiment, at least a portion of the second region 352 may extend in the first direction of the connector 300 (e.g., the positive Z-axis direction). In an embodiment, the second region 352 may include a loop shape. For example, referring to FIG. 4, the second region 352 may extend in the height direction of the connector 300 (e.g., the Z-axis direction) and may be bent at least partially and extend in the width direction of the connector 300 (e.g., the X-axis direction).

In an embodiment, the second region 352 may configured to contact or to be spaced apart from the first contact member 340 at a terminal end 352a.

In an embodiment, the third region 353 may be a region extending from one side of the second contact member 350 (e.g., the negative Y-axis direction side) and from the other side of the second contact member 350 (e.g., the positive Y-axis direction side). In an embodiment, the third region 353 may serve to fix a position of the second contact member 350 or to connect the second contact member 350 to another component of the connector 300.

In an embodiment, the second guide groove 333 of the base plate 330 may be grooves formed to allow at least a portion of the first contact member 340 to be disposed on the base plate 330. For example, at least a portion of the first contact member 340 may be disposed in the second guide groove 333 of the base plate 330. At least a portion of the first contact member 340 may be disposed in the second guide groove 333, and the first contact member 340 may thereby maintain a predetermined position in the connector 300.

FIG. 5 is a view illustrating a connector 300 and a printed circuit board 410 according to an embodiment of the disclosure.

FIG. 5 illustrates a state before the connector 300 according to an embodiment is disposed on the printed circuit board 410.

The printed circuit board 410 illustrated in FIG. 5 may refer to the printed circuit board 230 of FIG. 2 or may include at least a portion of the printed circuit board 230. For example, the printed circuit board 410 illustrated in FIG. 5 may refer to the first printed circuit board 231 or the second printed circuit board 232 of FIG. 2.

In an embodiment, the printed circuit board 410 may include an insertion opening 411, a fastening groove 412, and/or a contact portion 413.

In an embodiment, the connector 300 may be disposed such that the base plate 330 of the connector 300 is substantially parallel to the printed circuit board 410.

In an embodiment, the connector 300 may be disposed such that the first connection portion 310 and the second connection portion 320 face different directions with respect to the printed circuit board 410. For example, the connector 300 may be disposed such that the first connection portion 310 faces the positive Z-axis direction with respect to the printed circuit board 410. The connector 300 may be disposed such that the second connection portion 320 faces the negative Z-axis direction with respect to the printed circuit board 410.

In an embodiment, at least a portion of the connector 300 may be inserted into the insertion opening 411 in the printed circuit board 410. For example, the second connection portion 320 of the connector 300 may be inserted into the insertion opening 411 in the printed circuit board 410.

In an embodiment, the insertion opening 411 of the printed circuit board 410 may be formed in a shape corresponding to the second connection portion 320. For example, when the second connection portion 320 has a cylindrical shape, the insertion opening 411 may be formed in a circular shape corresponding to the circumference of the cylinder.

In an embodiment, at least a portion of the second connection portion 320 of the connector 300 may protrude in the negative Z-axis direction with respect to the printed circuit board 410 through the insertion opening 411.

Referring to FIG. 5, the printed circuit board 410 according to an embodiment may include one or more fastening grooves 412.

In an embodiment, the fixing regions 3112 and 3212 of the connector 300 may be inserted into the fastening grooves 412. The fastening grooves 412 may be formed at a positions corresponding to the fixing regions 3112 and 3212 of the connector 300. The fixing regions 3112 and 3212 may be partially inserted into the fastening grooves 412, and the connector 300 may thereby maintain a predetermined position.

Although the fixing regions 3112 and 3212 are illustrated in FIG. 5 as being formed in a loop shape, this is merely exemplary, and the fixing regions 3112 and 3212 may alternatively be formed to have a shape substantially parallel to the printed circuit board 410. When the fixing regions 3112 and 3212 have a shape substantially parallel to the printed circuit board 410, the fixing regions 3112 and 3212 may come into face-to-face contact with the printed circuit board 410 so that the connector 300 maintains a predetermined position.

Referring to FIG. 5, a contact portion 413 may be formed on one surface of the printed circuit board 410. In an embodiment, the contact portion 413 of the printed circuit board 410 may contact at least a portion of the connector 300. For example, the contact portion 413 of the printed circuit board 410 may contact the first contact member 340 of the connector 300. The contact portion 413 of the printed circuit board 410 may contact the first contact member 340 of the connector 300, and the printed circuit board 410 and the connector 300 may thereby be electrically connected.

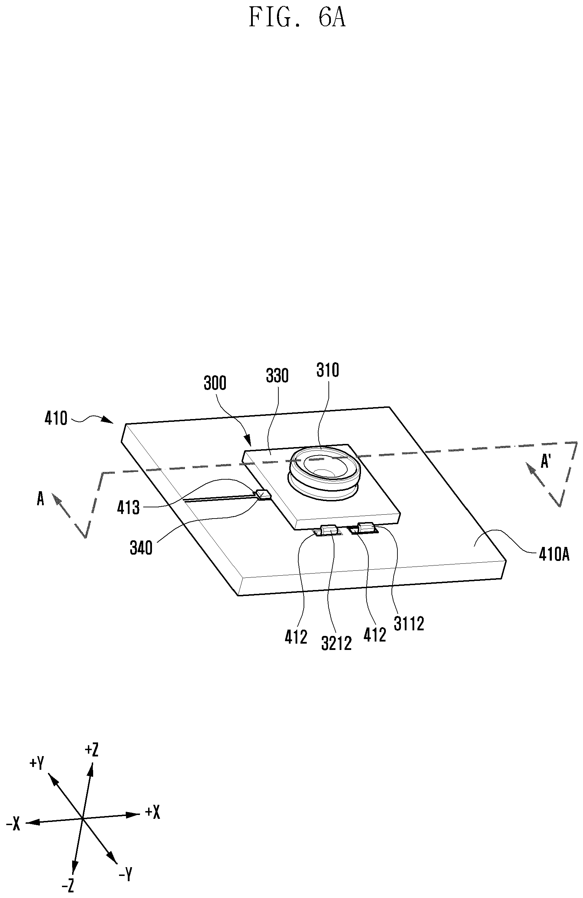

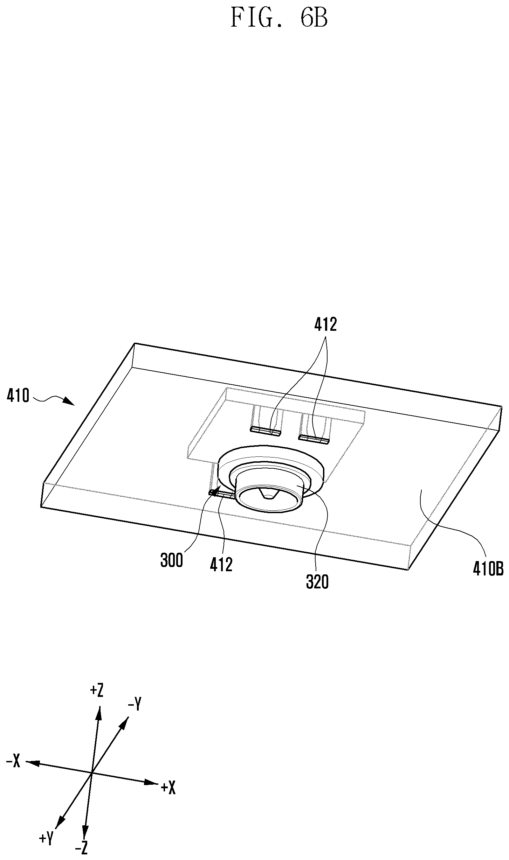

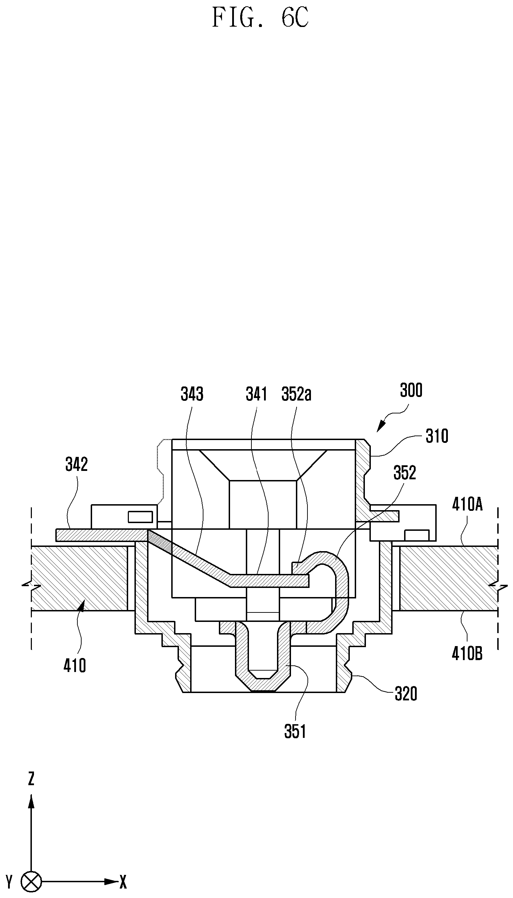

FIGS. 6A, 6B, and 6C are views illustrating a connector 300 disposed on a printed circuit board 410 according to an embodiment of the disclosure.

FIG. 6A is a view illustrating a first surface 410A of the printed circuit board 410 and a first connecting portion 310 of the connector 300. FIG. 6B is a view illustrating a second surface 410B of the printed circuit board 410 and a second connecting portion 320 of the connector 300. FIG. 6C is a cross-sectional view taken along line A-A' in FIG. 6A, illustrating the printed circuit board 410 and the connector 300.

Referring to FIG. 6A, the connector 300 may be disposed on the printed circuit board 410.

In an embodiment, a base plate 330 of the connector 300 may be disposed on the first surface 410A of the printed circuit board 410. In an embodiment, the base plate 330 may be in face-to-face contact with the first surface 410A of the printed circuit board 410. In an embodiment, the base plate 330 may be disposed substantially parallel to the first surface 410A of the printed circuit board 410.

Referring to FIG. 6A, fixing regions 3112 and 3212 of the connector 300 according to an embodiment may have portions inserted into fastening grooves 412 in the printed circuit board 410. The portions of the fixing region 3112 and 3212 may be inserted into the fastening grooves 412, so that the position of the connector 300 may be fixed on the printed circuit board 410.

Referring to FIG. 6A, when the connector 300 is disposed on the printed circuit board 410, a first contact member 340 of the connector 300 may contact a contact portion 413 of the printed circuit board 410. The first contact member 340 of the connector 300 may contact the contact portion 413 of the printed circuit board 410, and the connector 300 and the printed circuit board 410 may be electrically connected.

Referring to FIG. 6A, when the connector 300 according to an embodiment is disposed on the printed circuit board 410, the first connection portion 310 of the connector 300 may be disposed to face a direction substantially perpendicular to a first surface 410A of the printed circuit board 410. The first connection portion 310 may be disposed such that its terminal end faces a direction away from the first surface 410A (e.g., the positive Z-axis direction).

In an embodiment, a first direction of the printed circuit board 410 may refer to the positive Z-axis direction with respect to the printed circuit board 410. A second direction of the printed circuit board 410 may refer to the negative Z-axis direction with respect to the printed circuit board 410.

Referring to FIG. 6A, when the connector 300 according to an embodiment is disposed on the printed circuit board 410, the first connection portion 310 of the connector 300 may be coupled to a component (e.g., a first cable 420, see FIG. 7A) located in the first direction of the printed circuit board 410 (e.g., the positive Z-axis direction).

Referring to FIG. 6B, when the connector 300 according to an embodiment is disposed on the printed circuit board 410, the second connection portion 320 of the connector 300 may be disposed to face a direction substantially perpendicular to a second surface 410B of the printed circuit board 410. The second connection portion 320 may be disposed such that its terminal end faces a direction away from the second surface 410B (e.g., the negative Z-axis direction).

Referring to FIG. 6B, when the connector 300 according to an embodiment is disposed on the printed circuit board 410, the second connection portion 320 of the connector 300 may be coupled to a component (e.g., a second cable 430, see FIG. 8A) located in the second direction of the printed circuit board 410 (e.g., the positive Z-axis direction).

Referring to FIG. 6C, when the connector 300 according to an embodiment is disposed on the printed circuit board 410, the first connection portion 310 may be disposed in the first direction of the printed circuit board 410.

Referring to FIG. 6C, when the connector 300 according to an embodiment is disposed on the printed circuit board 410, a portion of the second connection portion 320 may be disposed to pass through the printed circuit board 410, and the remaining portion of the second connection portion 320 may be disposed in the second direction of the printed circuit board 410.

Referring to FIG. 6C, when another component (e.g., the first cable 420 (see FIG. 7A)) is not coupled to the first connection portion 310 and the second connection portion 320 of the connector 300, the second contact member 350 and the first contact member 340 may come into contact with each other. For example, the terminal end 352a of the second region 352 of the second contact member 350 may come into contact with a contact region 341 of the first contact member 340.

Referring to FIG. 6C, the first contact member 340 according to an embodiment may include the contact region 341, an inclined region 343 extending in an inclined direction from the contact region 341, and/or a placement region 342 extending from the inclined region 343.

Referring to FIG. 6C, the placement region 342 of the first contact member 340 may be disposed on the first surface 410A of the printed circuit board 410. In an embodiment, at least a portion of the placement region 342 of the first contact member 340 may come into contact with the printed circuit board 410. Although FIG. 6C illustrates that the placement region 342 is disposed to be spaced apart from the printed circuit board 410, this is merely exemplary, and the displacement region 342 may come into contact with a portion of the printed circuit board 410 and may be electrically connected thereto.

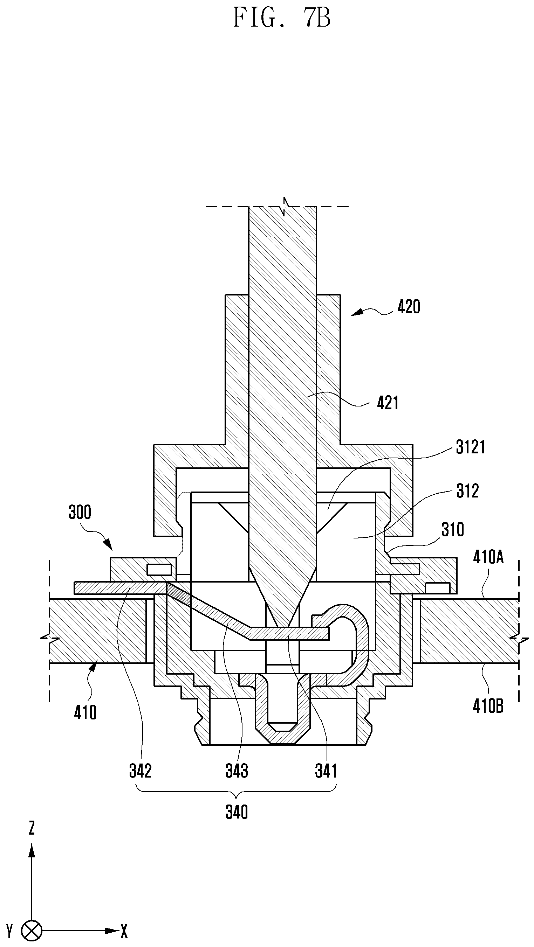

FIGS. 7A and 7B are views illustrating a state in which a first cable 420 is connected to a connector 300 according to an embodiment of the disclosure.

FIG. 7A is a view illustrating the connector 300, a printed circuit board 410, and the first cable 420 according to an embodiment. FIG. 7B is a cross-sectional view taken along line B-B' in FIG. 7A, illustrating the connector 300, the printed circuit board 410, and the first cable 420.

FIGS. 7A and 7B may be views illustrating a state in which the first cable 420 is connected to the connector 300 disposed on the printed circuit board 410.

In an embodiment, the first cable 420 may be a configuration in which its terminal end is positioned in the first direction of the printed circuit board 410 (e.g., the positive Z-axis direction). The first cable 420 may be coupled to the connector 300 in the first direction of the printed circuit board 410.

Referring to FIGS. 7A and 7B, the first cable 420 may be coupled to a portion of the connector 300. For example, the first cable 420 may be coupled to the first connection portion 310 of the connector 300.

In an embodiment, the first cable 420 may be a cable for an RF calibration process. The first cable 420 may be temporarily coupled to the first connection portion 310 of the connector 300 for the RF calibration process. The RF calibration process may be performed while the first cable 420 is temporarily coupled to the first connection portion 310 of the connector 300. In an embodiment, the first cable 420 may be decoupled from the connector 300 after completion of the RF calibration process.

Referring to FIG. 7B, when the first cable 420 is coupled to the first connection portion 310 of the connector 300, a contact pin 421 of the first cable 420 may be inserted into the insertion space 3121 of the first connection portion 310. The contact pin 421 of the first cable 420 may pass through the first filling member 312 and may protrude from the first filling member 312 such that its terminal end (e.g., the terminal end of the contact pin 421 facing the negative Z-axis direction) faces the first contact member 340.

Referring to FIG. 7B, when the first cable 420 is coupled to the first connection portion 310 of the connector 300, the contact pin 421 of the first cable 420 may contact the contact region 341 of the first contact member 340 of the connector 300 and may be electrically connected thereto.

Referring to FIG. 7B, the first contact member 340 according to an embodiment may include the contact region 341, an inclined region 343 extending in an inclined direction from the contact region 341, and/or a placement region 342 extending from the inclined region 343.

In an embodiment, since the first contact member 340 of the connector 300 is electrically connected to the printed circuit board 410 at the placement region 342, the contact pin 421 of the first cable 420 may be electrically connected to the printed circuit board 410.

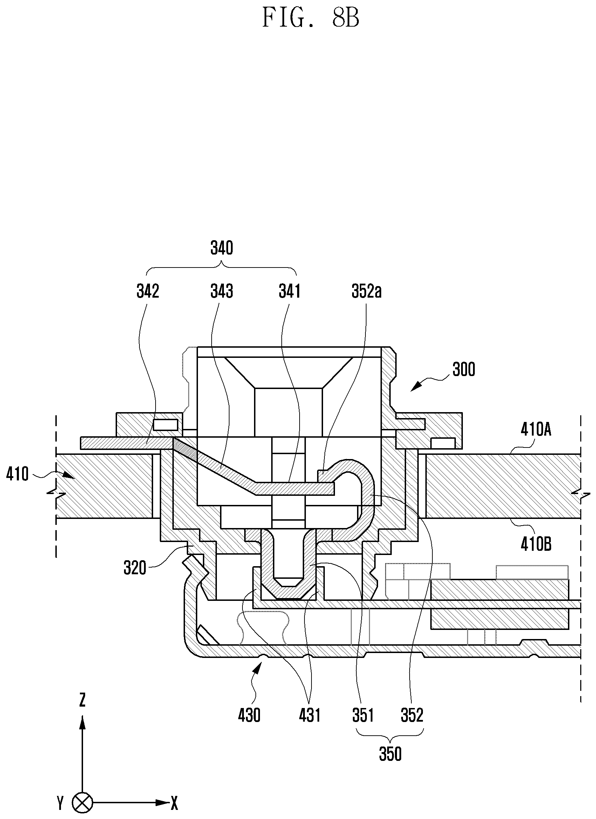

FIGS. 8A and 8B are views illustrating a state in which a second cable 430 is connected to a connector 300 according to an embodiment of the disclosure.

FIG. 8A is a view illustrating the connector 300, a printed circuit board 410, and the second cable 430 according to an embodiment. FIG. 8B is a cross-sectional view taken along line C-C' in FIG. 8A, illustrating the connector 300, the printed circuit board 410, and the second cable 430.

FIGS. 8A and 8B may be views illustrating a state in which the second cable 430 is connected to the connector 300 disposed on the printed circuit board 410.

In an embodiment, the second cable 430 may refer to the cable 240 illustrated in FIG. 2 or may include at least a portion of the cable 240 of FIG. 2.

In an embodiment, the second cable 430 may be a cable for RF signal transmission. For example, the second cable 430 may be a coaxial cable for transmitting RF signals between the printed circuit board 410 and another printed circuit board (e.g., 231 or 232 (see FIG. 2)).

In an embodiment, the second cable 430 may be a configuration in which its terminal end is positioned in the second direction of the printed circuit board 410 (e.g., the negative Z-axis direction). The second cable 430 may be coupled to the connector 300 in the second direction of the printed circuit board 410.

Referring to FIGS. 8A and 8B, the second cable 430 may be coupled to a portion of the connector 300. For example, the second cable 430 may be coupled to the second connection portion 320 of the connector 300.

Referring to FIG. 8B, when the second cable 430 is coupled to the second connection portion 320 of the connector 300, a contact pin 431 of the second cable 430 may be inserted into the inside of the second connection portion 320.

Referring to FIG. 8B, when the second cable 430 is coupled to the second connection portion 320 of the connector 300, the contact pin 431 of the second cable 430 may contact the second contact member 350 of the connector 300 and may be electrically connected thereto. For example, the contact pin 431 of the second cable 430 may contact the first region 351 of the second contact member 350.

In an embodiment, the second contact member 350 may contact, at the terminal end 352a of the second region 352, the first contact member 340 and be electrically connected thereto.

Referring to FIG. 8B, the first contact member 340 according to an embodiment may include the contact region 341, an inclined region 343 extending in an inclined direction from the contact region 341, and/or a placement region 342 extending from the inclined region 343.

In an embodiment, the first contact member 340 may contact, at the placement region 342, the printed circuit board 410 and be electrically connected thereto. The contact pin 431 of the second cable 430 may be electrically connected to the printed circuit board 410 through the second contact member 350 and the first contact member 340.

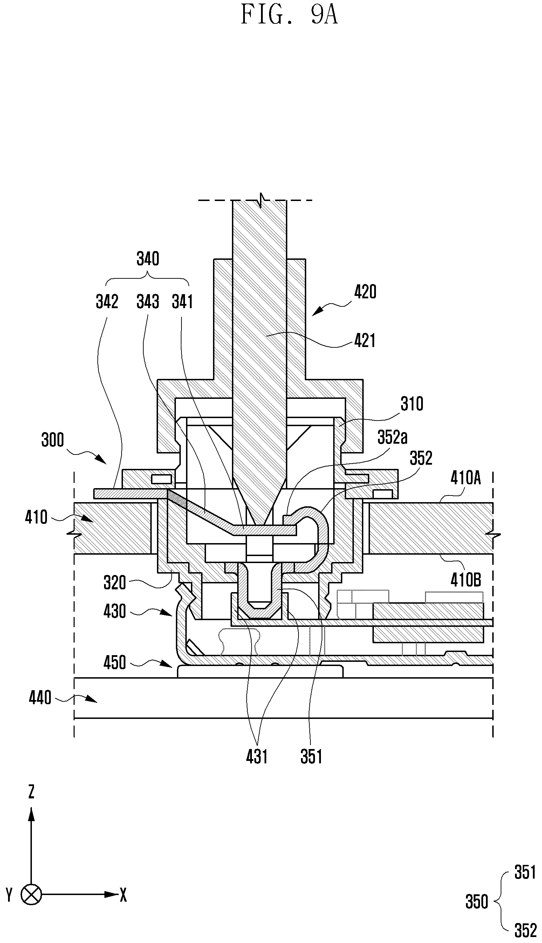

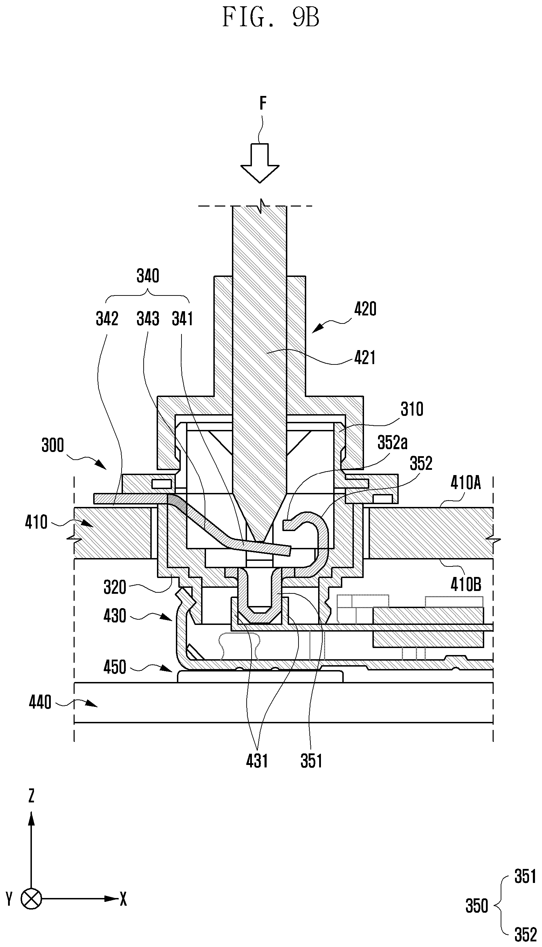

FIGS. 9A and 9B illustrate states in which a first cable 420 and a second cable 430 are connected to a connector 300 according to an embodiment disclosed herein.

FIGS. 9A and 9B may be views illustrating states in which the first cable 420 and the second cable 430 are connected to the connector 300 disposed on a printed circuit board 410. For example, FIGS. 9A and 9B may be cross-sectional views taken along line A-A' in FIG. 6A, illustrating states in which the first cable 420 and the second cable 430 are connected to the printed circuit board 410 and the connector 300.

FIG. 9A is a view illustrating a first coupling state between the connector 300 and the first cable 420. FIG. 9B is a view illustrating a second coupling state between the connector 300 and the first cable 420.

In an embodiment, the first coupling state between the connector 300 and the first cable 420 may refer to a state in which the first cable 420 is not fully coupled to, but is merely disposed on, the connector 300.

In an embodiment, the second coupling state between the connector 300 and the first cable 420 may refer to a state in which the first cable 420 is fully coupled to the connector 300. In the second coupling state, the first cable 420 may be disposed at a position in which its terminal end is moved toward the printed circuit board 410 (e.g., in the negative Z-axis direction) compared to the first coupling state.

Referring to FIG. 9A, in the first coupling state between the connector 300 and the first cable 420, a contact pin 421 of the first cable 420 may contact the first contact member 340 and may be electrically connected thereto. In the first coupling state, since the first contact member 340 contacts and is electrically connected to the printed circuit board 410, the first cable 420 may be electrically connected to the printed circuit board 410. In the first coupling state, the first contact member 340 may contact the second contact member 350. In the first coupling state, since the first contact member 340 contacts and is electrically connected to the second contact member 350, the first cable 420 may be electrically connected to the second contact member 350.

Referring to FIG. 9B, in the second coupling state between the connector 300 and the first cable 420, the contact pin 421 of the first cable 420 may receive a fastening force F from the outside and may be moved toward the bracket 440 (e.g., in the negative Z-axis direction) compared to the first coupling state. As the contact pin 421 of the first cable 420 moves, the first contact member 340 may be elastically deformed. For example, the contact pin 421 of the first cable 420 may push a contact region 341 of the first contact member 340 in the negative Z-axis direction, and the first contact member 340 may be elastically deformed. As the first contact member 340 is elastically deformed, the contact region 341 of the first contact member 340 may be spaced apart from the terminal end 352a of the second contact member 350.

In an embodiment, in the second coupling state between the connector 300 and the first cable 420, since the first contact member 340 and the second contact member 350 do not contact each other, the second cable 430 may not be electrically connected to the printed circuit board 410. For example, when the first contact member 340 and the second contact member 350 contact each other, the second cable 430 may be electrically connected to the printed circuit board 410 through the first contact member 340 and the second contact member 350, but when the first contact member 340 and the second contact member 350 do not contact each other, the second cable 430 may not be electrically connected to the printed circuit board 410.

In an embodiment, in the second coupling state between the connector 300 and the first cable 420, since the second cable 430 is not electrically connected to the printed circuit board 410, an RF calibration process using the first cable 420 may be facilitated.

Referring to FIGS. 9A and 9B, a support member 440 may be disposed in the negative Z-axis direction with respect to the printed circuit board 410 and the second cable 430.

The support member 440 illustrated in FIGS. 9A and 9B may refer to the support member 220 of FIG. 2 or may include at least a portion of the support member 220 of FIG. 2. For example, the support member 440 may be the first support member 221 or the second support member 222 of FIG. 2.

In an embodiment, the support member 440 may serve to support the printed circuit board 410. In an embodiment, the support member 440 may serve to fix the position of the printed circuit board 410.

Referring to FIGS. 9A and 9B, the second cable 430 according to an embodiment may be disposed between the support member 440 and the printed circuit board 410. In an embodiment, the support member 440 may include a guide structure (not illustrated) configured to fix a position of the second cable 430.

In an embodiment, the second cable 430 may be electrically connected to the support member 440. For example, the second cable 430 may be grounded to the support member 440.

In an embodiment, the second cable 430 may be grounded to the support member 440, and parasitic resonance generated by the second cable 430 may be removed or reduced.

In an embodiment, a conductive member 450 may be disposed between the second cable 430 and the support member 440.

In an embodiment, the conductive member 450 may be a conductive double-sided tape. In an embodiment, the conductive member 450 may include a conductive sponge.

In an embodiment, the conductive member 450 may include a conductive material so as to allow the second cable 430 to be grounded to the support member 440.

In an embodiment, the conductive member 450 may serve to couple the second cable 430 and the support member 440. For example, the second cable 430 may be attached to one surface of the conductive member 450, and the support member 440 may be attached to the other surface of the conductive member 450, so that the second cable 430 and the support member 440 may be coupled.

In an embodiment, the first cable 420 may be coupled to the first connection portion 310 of the connector 300 positioned in a direction opposite to a direction in which the support member 440 is positioned with respect to the printed circuit board 410.

The electronic device 200 (see FIG. 2) according to an embodiment of the disclosure may not require separation of the printed circuit board 410 and the support member 440 for performing an RF calibration process, since the first cable 420 for RF calibration is coupled to the connector 300 positioned on the printed circuit board 410 from a direction opposite to the direction in which the support member 440 is positioned with respect to the printed circuit board 410.

The electronic device 200 (see FIG. 2) according to an embodiment of the disclosure may reduce time required for an RF calibration process, since separation of the printed circuit board 410 and the support member 440 is not required for performing the RF calibration process.

In FIGS. 9A and 9B, the connector 300 is illustrated as being coupled to different types of cables 420 and 430 in one direction (e.g., the positive Z-axis direction) and the other direction (e.g., the negative Z-axis direction), but the types of cables 420 and 430 coupled to the connector 300 may not be limited thereto. For example, the connector 300 may be coupled to the second cable 430 for RF signal transmission in each of the one direction and the other direction. When the connector 300 is connected to the second cable 430 for RF signal transmission in both directions, multiple second cables 430 may be disposed while using an internal space of the electronic device 200 (see FIG. 2) more efficiently.

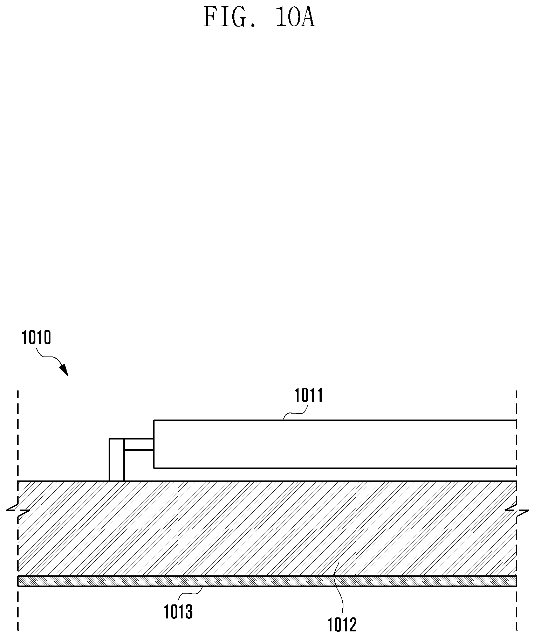

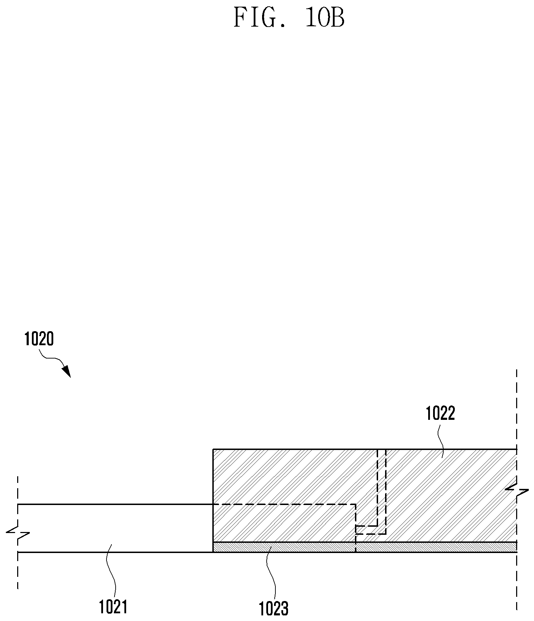

FIGS. 10A and 10B are views illustrating electronic devices 1010 and 1020 according to an embodiment.

FIG. 10A is a view illustrating an electronic device 1010 according to a comparative embodiment. FIG. 10B is a view illustrating an electronic device 1020 according to an embodiment of the disclosure.

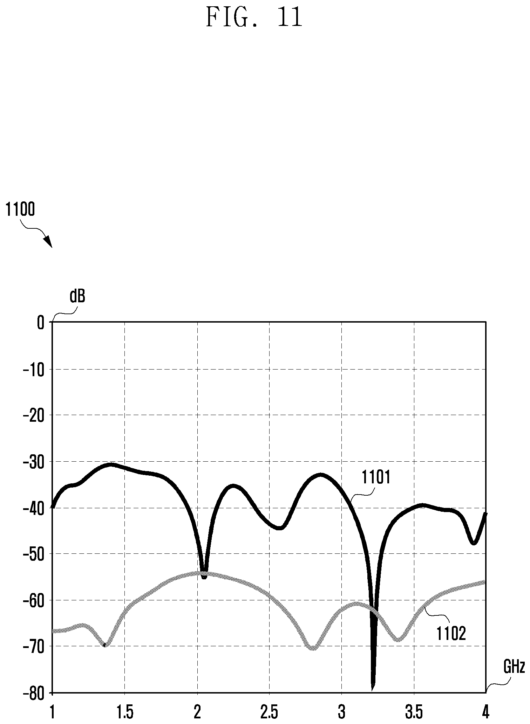

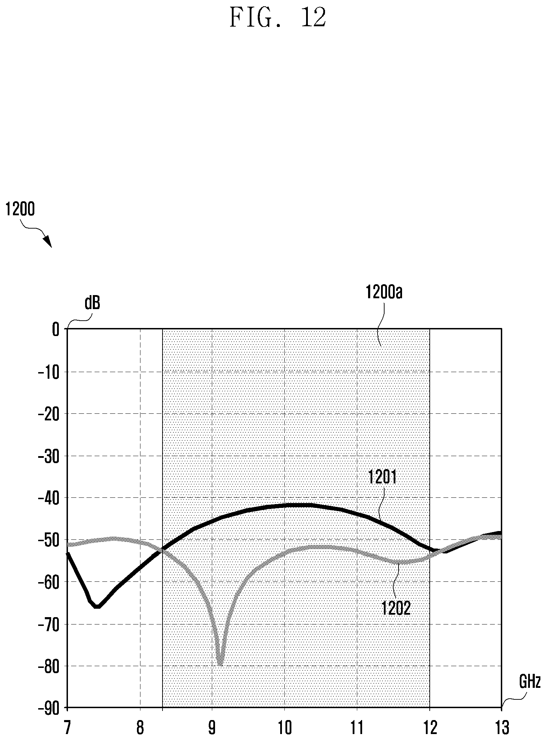

FIGS. 11 and 12 are graphs illustrating noise simulation results of the electronic devices 1010 and 1020.

FIG. 11 may be a graph 1100 illustrating noise simulation results when noise in a 1 to 4 GHz band is implemented in the electronic devices 1010 and 1020. FIG. 12 may be a graph 1200 illustrating noise simulation results when noise in a 7 to 13 GHz band is implemented in the electronic devices 1010 and 1020.

Referring to FIG. 10A, the electronic device 1010 according to a comparative embodiment may include a cable 1011, a printed circuit board 1012, and/or a ground 1013. The cable 1011 may be a coaxial cable for RF signal transmission.

In the comparative embodiment, the ground 1013 may be disposed in one direction of the printed circuit board 1012, and the cable 1011 may be disposed in the other direction of the printed circuit board 1012. For example, in the electronic device 1010 of FIG. 10A, the ground 1013 may be disposed in a direction opposite to the direction in which the cable 1011 is positioned with respect to the printed circuit board 1012.

The electronic device 1020 of FIG. 10B may refer to the electronic device 200 of FIG. 2 or may include at least some of the components of the electronic device 200 of FIG. 2.

Referring to FIG. 10B, the electronic device 1020 according to an embodiment of the disclosure may include a cable 1021, a printed circuit board 1022, and/or a ground 1023. The cable 1021 may be a coaxial cable for RF signal transmission.

In an embodiment, the ground 1023 and the cable 1021 may be disposed in one direction of the printed circuit board 1022. For example, in the electronic device 1020 of FIG. 10B, at least a portion of the cable 1021 may be positioned in the same direction as the direction in which the ground 1023 is positioned with reference to the printed circuit board 1022.

In the electronic device 1020 according to an embodiment of the disclosure, the cable 1021 may be grounded by being brought into contact with the ground 1023 in the one direction of the printed circuit board 1022.

The horizontal axes of the graphs 1100 and 1200 illustrated in FIGS. 11 and 12 may represent frequencies (e.g., gigahertz (GHz)) of noise generated in the electronic devices 1010 and 1020. The vertical axes of the graphs 1100 and 1200 illustrated in FIGS. 11 and 12 may represent levels (e.g., decibel (dB)) of noise generated in the electronic devices 1010 and 1020.

Referring to the graph 1100 of FIG. 11, a first noise level 1101 may indicate a noise level when noise in a band of 1 to 4 GHz is implemented in the electronic device 1010 according to a comparative embodiment. A second noise level 1102 may indicate a noise level when noise in a band of 1 to 4 GHz is implemented in the electronic device 1020 according to an embodiment of the disclosure.

Referring to the graph 1100 of FIG. 11, the second noise level 1102 may be formed substantially smaller than the first noise level 1101.

The fact that the second noise level 1102 is formed substantially smaller than the first noise level 1101 may indicate that noise caused by the cable 1021 is reduced in the electronic device 1020 according to an embodiment of the disclosure compared to the electronic device 1010 according to the comparative embodiment. In the electronic device 1020 according to an embodiment of the disclosure, since the cable 1021 is grounded by being brought into contact with the ground 1023 in one direction of the printed circuit board 1022, parasitic resonance caused by the cable 1021 is reduced, and noise in the band of 1 to 4 GHz may be substantially reduced compared to the electronic device 1010 according to the comparative embodiment.

Referring to the graph 1200 of FIG. 12, a third noise level 1201 may indicate a noise level when noise in a band of 7 to 13 GHz is implemented in the electronic device 1010 according to a comparative embodiment. A fourth noise level 1202 may indicate a noise level when noise in a band of 7 to 13 GHz is implemented in the electronic device 1020 according to an embodiment of the disclosure.

Referring to the graph 1200 of FIG. 12, the fourth noise level 1202 may be formed substantially smaller than the third noise level 1201. For example, in the shaded display region 1200a on the graph 1200, the fourth noise level 1202 may be formed smaller than a third noise level 1201.

The fact that the fourth noise level 1202 is formed substantially smaller than the third noise level 1201 may indicate that noise caused by the cable 1021 is reduced in the electronic device 1020 according to an embodiment of the disclosure compared to the electronic device 1010 according to the comparative embodiment. In the electronic device 1020 according to an embodiment of the disclosure, since the cable 1021 is grounded by being brought into contact with the ground 1023 in one direction of the printed circuit board 1022, parasitic resonance caused by the cable 1021 is reduced, and noise in the band of 7 to 13 GHz may be substantially reduced compared to the electronic device 1010 according to the comparative embodiment.

According to an embodiment of the disclosure, an electronic device may include a housing 210, a support member 220 disposed in the housing 210, a first printed circuit board 231 disposed on the support member 220, a second printed circuit board 232 disposed on the support member 220 and positioned at a distance from the first printed circuit board 231, a cable 240 configured to electrically connect the first printed circuit board 231 and the second printed circuit board 232, and a connector 250 or 300 disposed on at least one of the first printed circuit board 231 and the second printed circuit board 232. The connector 300 may include a first connection portion 310 protruding in a first direction of the first printed circuit board 231 and the second printed circuit board 232 for RF calibration, and a second connection portion 320 protruding in a second direction opposite to the first direction of the first printed circuit board 231 and the second printed circuit board 232 and connected to the cable 240.

In an embodiment, the cable 240 or 430 may be coupled to the connector 300 in one direction of a terminal end thereof, and may be grounded to the support member 220 or 440 in another direction opposite to the one direction of the terminal end.

In an embodiment, the electronic device 200 may further include a conductive member 450 disposed between the terminal end of the cable 240 or 430 and the support member 220 or 440.

In an embodiment, the connector 300 may include a base plate 330 including an opening 331.

In an embodiment, at least a portion of the first connection portion 310 may extend through the opening 331 of the base plate 330.

In an embodiment, the connector 300 may include a first contact member 340 configured to contact the printed circuit board 410 on which at least a portion of the connector 300 is disposed, and a second contact member 350 configured to contact the cable 240 or 430 and be electrically connected thereto.

In an embodiment, the second contact member 350 may include a first region 351 extending toward the cable 240 or 430, and a second region 352 formed in a loop shape and configured to contact the first contact member 340 at a terminal end 352a thereof.

In an embodiment, the electronic device 200 may include a first cable 420 for RF calibration and a second cable 430 including the cable 240.

In an embodiment, the first contact member 340 may be configured to contact the second contact member 350 when the first cable 420 is not fastened to the first connection portion 310, and may be configured to be moved by the first cable 420 and spaced apart from the second contact member 350 when the first cable 420 is fastened to the first connection portion 310.

In an embodiment, the first contact member 340 may include a contact region 341 configured to contact the first cable 420, a placement region 342 configured to contact the printed circuit board 410 on which the connector 300 is disposed, and an inclined region 343 extending between the contact region 341 and the placement region 342.

In an embodiment, the connector 300 may include a fixing region 3112 or 3212, and a printed circuit board on which the connector 300 is disposed among the first printed circuit board 231 and the second printed circuit board 232 may include a fastening groove 412 into which a portion of the fixing region 3112 or 3212 is inserted.

In an embodiment, the connector 300 may include a base plate 330, and the base plate 330 may include a guide groove 332 in which the fixing region 3112 or 3212 is disposed.

In an embodiment, the fixing region 3112 or 3212 may include a first fixing region 3112 formed on the first connection portion 310, and a second fixing region 3212 disposed at a distance from the first fixing region 3112 or 3212 and formed on the second connection portion 320.

In an embodiment, the first connection portion 310 may include a first conductive member 311 including a conductive material, and a first filling member 312 formed inside the first conductive member 311 and including a first insertion space 3121.

In an embodiment, the second connection portion 320 may include a second conductive member 321 including a conductive material, and a second filling member 322 formed inside the second conductive member 321 and including a second insertion space 3221.

In an embodiment, each of the first conductive member 311 and the second conductive member 321 may include a base region 3111 or 3211 on which the fixing region 3112 or 3212 is formed, and a coupling region 3113 or 3213 extending from the base region 3111 or 3211 in a height direction of the connector 300 and having a cylindrical shape.

In an embodiment, the electronic device 300 may further include a battery 260, and the first printed circuit board 231 and the second printed circuit board 232 may be disposed with the battery 260 interposed therebetween.

At least a portion of the cable 240 or 430 may extend along a length direction of the electronic device 300 at one side of the battery 260.

According to an embodiment of the disclosure, the connector 300 may include a first connection portion 310 protruding in a first direction and configured for RF calibration, a second connection portion 320 protruding in a second direction opposite to the first direction and connected to a cable 430 for RF signal transmission, a base plate 330 including an opening 331 through which at least a portion of the first connection portion 310 extends, a first contact member 340 configured to contact the printed circuit board 410 on which at least a portion of the connector 300 is disposed, and a second contact member 350 configured to contact the cable and be electrically connected thereto.

In an embodiment, the first contact member 340 may be configured to contact the second contact member 350 when an external cable is not fastened to the first connection portion 310, and may be configured to be moved by the external cable and spaced apart from the second contact member 350 when the external cable is fastened to the first connection portion 310.

The electronic device according to an embodiment of the disclosure may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C,""at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in an embodiment of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

An embodiment of the disclosure may be implemented as software (e.g., the program 101) including one or more instructions that are stored in a storage medium (e.g., the internal memory 136 or external memory 138) that is readable by a machine (e.g., the electronic device 140). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include codes generated by a compiler or code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a purchaser. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may also be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to an embodiment, operations performed by the module, the program, or another element may be carried out sequentially, in parallel, repeatedly, or heuristically, or one or more of the operations may be executed in a different order or omitted, or one or more other operations may be added.

## Claims

1. An electronic device comprising:
a housing (210) having a support member (220);
a first printed circuit board (231) disposed on the support member;
a second printed circuit board (232) disposed on the support member and positioned at a distance from the first printed circuit board;
a cable (240) electrically connecting the first printed circuit board and the second printed circuit board; and
a connector (250, 300) disposed on at least one of the first printed circuit board and the second printed circuit board,
wherein the connector comprises:
a first connection portion (310) protruding in a first direction of the first printed circuit board and the second printed circuit board and configured for RF calibration, and
a second connection portion (320) protruding in a second direction opposite to the first direction of the first printed circuit board and the second printed circuit board and connected to the cable.

2. The electronic device of claim 1, wherein the cable is coupled to the connector in one direction of a terminal end thereof, and is grounded to the support member in another direction opposite to the one direction of the terminal end.

3. The electronic device of claim 2, further comprising:
a conductive member (450) disposed between the terminal end of the cable and the support member.

4. The electronic device of claim 1, wherein the connector further comprises a base plate (330) comprising an opening (331), and
wherein at least a portion of the first connection portion extends through the opening of the base plate.

5. The electronic device of claim 1, wherein the connector comprises:
a first contact member (340) configured to contact the printed circuit board on which at least a portion of the connector is disposed, and
a second contact member (350) configured to contact and be electrically connected to the cable.

6. The electronic device of claim 5, wherein the second contact member comprises:
a first region (351) extending toward the cable, and
a second region (352) formed in a loop shape and configured to contact the first contact member at a terminal end (352a) thereof.

7. The electronic device of claim 5, further comprising:
a first cable (420) for RF calibration; and
a second cable (430) comprising the cable,
wherein the first contact member is configured to contact the second contact member when the first cable is not fastened to the first connection portion, and
wherein the first contact member is configured to be moved by the first cable and spaced apart from the second contact member when the first cable is fastened to the first connection portion.

8. The electronic device of claim 7, wherein the first contact member comprises:
a contact region (341) configured to contact the first cable,
a placement region (342) configured to contact the printed circuit board on which the connector is disposed, and
an inclined region (343) extending between the contact region and the placement region.

9. The electronic device of claim 1, wherein the connector comprises a fixing region (3112, 3212), and
wherein a printed circuit board on which the connector is disposed among the first printed circuit board and the second printed circuit board comprises a fastening groove (412) into which a portion of the fixing region is inserted.

10. The electronic device of claim 9, wherein the connector further comprises a base plate (330), and
wherein the base plate comprises a guide groove (332) in which the fixing region is disposed.

11. The electronic device of claim 9, wherein the fixing region comprises:
a first fixing region (3112) formed on the first connection portion, and
a second fixing region (3212) disposed at a distance from the first fixing region and formed on the second connection portion.

12. The electronic device of claim 1, wherein the first connection portion comprises:
a first conductive member (311) comprising a conductive material, and
a first filling member (312) formed inside the first conductive member and comprising a first insertion space (3121), and
wherein the second connection portion comprises:
a second conductive member (321) comprising a conductive material, and
a second filling member (322) formed inside the second conductive member and comprising a second insertion space (3221).

13. The electronic device of claim 12, wherein each of the first conductive member and the second conductive member comprises:
a base region (3111, 3211) on which the fixing region is formed; and
a coupling region (3113, 3213) extending from the base region in a height direction of the connector and having a cylindrical shape.

14. The electronic device of claim 1, further comprising:
a battery (260),
wherein the first printed circuit board and the second printed circuit board are disposed with the battery interposed therebetween, and
wherein at least a portion of the cable extends along a length direction of the electronic device at one side of the battery.

15. A connector comprising:
a first connection portion (310) protruding in a first direction and configured for RF calibration;
a second connection portion (320) protruding in a second direction opposite to the first direction and connected to a cable (430) for RF signal transmission;
a base plate (330) including an opening (331) through which at least a portion of the first connection portion extends;
a first contact member (340) configured to contact a printed circuit board (410) on which at least a portion of the connector is disposed; and
a second contact member (350) configured to contact the cable and be electrically connected thereto.
